# FASCICULE DE BREVET EUROPEEN

(11) **EP 4 137 945 B1**
(45) Date de publication et mention de la délivrance du brevet: **02.12.2026**
(21) Numéro de dépôt: 22188571.8
(22) Date de dépôt: 03.08.2022
(51) Int. Cl.: G06F 11/16, H03K 19/007, G06F 11/07

(54) **MÉTHODE DE PROTECTION D'UN CIRCUIT INTÉGRÉ NUMÉRIQUE RECONFIGURABLE CONTRE LES ERREURS RÉVERSIBLES**
VERFAHREN ZUM SCHUTZ EINES REKONFIGURIERBAREN DIGITALEN INTEGRIERTEN SCHALTKREISES GEGEN REVERSIBLE FEHLER
METHOD FOR PROTECTING A RECONFIGURABLE DIGITAL INTEGRATED CIRCUIT AGAINST REVERSIBLE ERRORS

(30) Priorité: 12.08.2021 FR 2108653
(43) Date de publication de la demande: 22.02.2023
(73) Titulaire: THALES, 92400 Courbevoie (FR)
(72) Inventeur: OSTER, Yann, 31037 TOULOUSE Cedex (FR)
(74) Mandataire: Atout PI Laplace

(56) Documents cités:
- EP-B1- 3 392 773
- US-A1- 2019 303 260
- EBRAHIM ALI ET AL: "A fast and scalable FPGA damage diagnostic service for R3TOS using BIST cloning technique", 2014 24TH INTERNATIONAL CONFERENCE ON FIELD PROGRAMMABLE LOGIC AND APPLICATIONS (FPL), TECHNICAL UNIVERSITY OF MUNICH (TUM), 2 September 2014 (2014-09-02), pages 1 - 4, XP032662423, DOI: 10.1109/FPL.2014.6927386
- ANKIT AGARWAL ET AL: "State model for scheduling Built-in Self-Test and scrubbing in FPGA to maximize the system availability in space applications", POWER ELECTRONICS (IICPE), 2010 INDIA INTERNATIONAL CONFERENCE ON, IEEE, 28 January 2011 (2011-01-28), pages 1 - 7, XP031929729, ISBN: 978-1-4244-7883-5, DOI: 10.1109/IICPE.2011.5728146

## Description

L'invention concerne le domaine des circuits intégrés numériques reconfigurables, ou circuits à logique programmable tels que les circuits FPGA (Field Programmable Gate Array).

Plus précisément, l'invention concerne les mécanismes de protection de tels circuits intégrés numériques contre les erreurs réversibles induites en particulier par les radiations auxquelles ces circuits sont soumis.

Les circuits intégrés numériques peuvent être soumis à des radiations ou particules ionisantes qui engendrent des erreurs transitoires ou réversibles sur le circuit et perturbent son fonctionnement nominal.

Dans le cas d'applications aéroportées ou aérospatiales, les circuits intégrés numériques sont exposés aux effets des radiations ionisantes provenant de l'environnement extérieur. Dans une moindre mesure, même pour des applications embarquées dans des systèmes au sol, les boîtiers dans lesquels les circuits sont encapsulés génèrent des radiations alpha qui engendrent des erreurs avec une occurrence d'autant plus élevée que les circuits sont complexes et comprennent un très grand nombre de portes logiques.

Les effets produits par les radiations sur un circuit peuvent être progressifs ou singuliers. Dans le premier cas, les défauts générés par les radiations sont progressivement accumulés jusqu'à générer des erreurs à partir d'un certain seuil de dose de radiations accumulées. Dans le second cas, une seule particule ionisante ou un seul évènement peut générer un défaut immédiat qui peut affecter les mémoires, les bascules ou les portes logiques que contient le circuit. Si le défaut génère une inversion d'un bit, on parle de « single event upset » (SEU), si au contraire il impacte plusieurs bits, on parle de « multiple-bit upset » (MBU). Les effets des radiations peuvent prendre la forme de parasites ou impulsions qui se propagent dans le circuit et affectent la logique combinatoire au niveau d'un fil électrique ou d'une porte logique (on parle de « single event transient » (SET) dans ce cas). Ces erreurs (SEU, MBU, SET) sont réversibles et n'affectent que l'interprétation des signaux électriques dans la logique séquentielle et combinatoire, avec pour conséquences, des erreurs logiques qui impactent le circuit.

Par ailleurs, les circuits dits COTS « Commercial Off-the shelf » sont en général plus sensibles aux erreurs réversibles que les circuits en technologie durcie spécifique, conduisant à des erreurs en sortie des fonctions, voire à des modifications persistantes des fonctions implantées.

Les erreurs transitoires peuvent affecter l'état interne des automates des fonctions (au niveau applicatif) ou bien la mémoire de configuration (au niveau de la configuration des fonctions) qui définit le circuit implanté avec les ressources du circuit. En effet, les circuits de type FPGA reconfigurables ont une configuration stockée en mémoire qui définit la fonctionnalité à implémenter. Les mémoires de configuration sont par exemple des mémoires en technologique SRAM ou Flash.

Les mémoires SRAM sont, en particulier, très sensibles aux erreurs réversibles.

De façon générale, une erreur impactant une mémoire de configuration engendre des erreurs de configuration du circuit conduisant à la mise en œuvre de fonctionnalités erronées.

Il existe donc un besoin pour un mécanisme de protection ayant pour fonction de masquer l'impact des erreurs réversibles sur les circuits intégrés reconfigurables, que ces erreurs agissent sur les fonctions logiques du circuit ou sur la mémoire de configuration.

Le mécanisme de protection doit être prévu pour tolérer tout type d'erreurs réversibles en induisant une complexité et une consommation limitée. Par ailleurs, l'impact du mécanisme de protection sur la vitesse de traitement du circuit doit être limité et ne doit pas entrainer d'interruption de service.

La demande de brevet français FR 3065601 du Demandeur propose un mécanisme de protection aux erreurs transitoires pour des circuits de type FPGA ou ASIC. Cette solution permet de corriger l'effet des erreurs réversibles sur la logique du circuit, cependant elle ne permet pas de prendre en compte l'effet d'erreurs sur la mémoire de configuration du circuit.

Un mécanisme connu pour corriger l'effet d'erreurs sur une mémoire de configuration consiste à utiliser une mémoire redondante insensible aux radiations, par exemple une mémoire ROM de référence. Une comparaison est réalisée à intervalles réguliers entre la mémoire de configuration SRAM et la mémoire ROM de référence.

Une autre solution consiste à reprogrammer périodiquement la mémoire de configuration de manière à effectuer une correction préventive.

D'autres solutions sont basées sur l'emploi de codes correcteurs d'erreurs ou de code détecteurs d'erreurs.

On connait également les solutions décrites dans le document « A fast and scalable FPGA damage diagnostic service for R3TOS using BIST cloning technique, Ebrahim Ali et al, Technical University of Munich », ainsi que la demande de brevet US 2019/303260.

L'ensemble de ces solutions présentent des inconvénients en termes d'interruption de service, de vitesse de fonctionnement et/ou de surconsommation induite pour le circuit.

L'invention propose un mécanisme de protection d'un circuit intégré numérique reconfigurable aux erreurs réversibles prenant en compte à la fois l'impact des erreurs sur la logique du circuit et sur la mémoire de configuration.

Le mécanisme proposé fonctionne sans interruption de service, présente une complexité limitée et un impact limité sur la vitesse de fonctionnement du circuit protégé.

L'invention a ainsi pour objet une méthode de protection, contre les erreurs réversibles, d'un circuit intégré numérique reconfigurable au moyen d'une mémoire de selon la revendication 1.

Selon un mode de réalisation particulier de l'invention, la méthode comprend en outre les étapes suivantes exécutées immédiatement après la première étape d'activer l'unité de détection d'erreur :
- en réponse à une erreur détectée par l'unité de détection d'erreur dans au moins un canal de traitement, exécuter le mécanisme de rejeu de données pour chaque canal de traitement, puis
- activer l'unité de détection d'erreur pour détecter une erreur dans au moins un canal de traitement,

Selon un mode de réalisation particulier de l'invention, l'étape d'exécuter le mécanisme de rejeu de données comprend les sous- étapes de :
- réinitialiser le bloc logique fonctionnel,
- exécuter, à un rythme supérieur au rythme nominal d'exécution du circuit intégré, le bloc logique fonctionnel pour des données antérieures sauvegardées dans une mémoire tampon.

Selon une variante particulière, la méthode selon l'invention comprend en outre une étape de synchronisation, après reconfiguration, du canal de traitement pour lequel une erreur a été détectée par l'autotest avec les autres canaux de traitements.

Selon un mode de réalisation particulier de l'invention, l'étape de détecter une erreur dans au moins un canal de traitement consiste au moins à comparer les sorties de tous les canaux de traitement et à déclarer la présence d'une erreur si toutes les sorties ne sont pas identiques.

Selon un mode de réalisation particulier de l'invention, les nombres traités par le circuit intégré numérique sont codés selon un système modulaire de représentation par les résidus dit RNS dans lequel les nombres sont exprimés dans une base de représentation RNS définie par une pluralité de modules mutuellement premiers entre eux, un nombre étant codé par un vecteur dont chaque composante correspond au modulo du nombre par un module de la base RNS, chaque canal de traitement étant destiné à traiter une composante et l'ensemble des canaux de traitement comprenant au moins un canal associé à une composante redondante.

Selon un mode de réalisation particulier de l'invention, l'étape de détecter une erreur dans au moins un canal de traitement consiste au moins à :
- Convertir les composantes en sortie de l'ensemble des canaux de traitements en un nombre,
- Détecter une erreur si ce nombre dépasse la dynamique de la base RNS sans redondance.

Selon un mode de réalisation particulier de l'invention, la dynamique d'entrée des nombres traités par le circuit intégré numérique est adaptable de manière à associer indistinctement au moins un canal de traitement à une composante redondante.

L'invention a aussi pour objet un ensemble d'au moins un circuit intégré numérique reconfigurable comprenant plusieurs canaux de traitement parallèles comprenant chacun une instance d'un bloc logique fonctionnel, une mémoire de configuration de l'au moins un circuit, une unité de détection d'erreur à partir des sorties des canaux de traitement et un contrôleur, chaque circuit implémentant un mécanisme de re-jeu de données et un mécanisme d'autotest des canaux de traitement, le contrôleur étant configuré pour commander les éléments de l'au moins un circuit intégré numérique de manière à implémenter une méthode de protection contre les erreurs réversibles selon l'invention.

Selon un mode particulier de réalisation, ledit ensemble comprend une mémoire FIFO d'entrée pour alimenter en échantillons chaque canal de traitement, une mémoire FIFO de sortie pour recevoir des échantillons provenant de l'unité de détection d'erreur, une mémoire tampon alimentée en échantillons par la mémoire FIFO d'entrée , le contrôleur étant apte à commander l'accès en lecture dans la mémoire FIFO d'entrée et l'accès en écriture dans la mémoire FIFO de sortie et étant configuré pour exécuter un mécanisme de rejeu consistant à réinitialiser chaque bloc logique fonctionnel, suspendre l'accès en lecture dans la mémoire FIFO d'entrée, suspendre l'accès en écriture dans la mémoire FIFO de sortie et basculer l'entrée des canaux de traitements vers la sortie de la mémoire tampon .

Selon un mode particulier de réalisation, ledit ensemble comprend en outre un générateur de stimuli d'autotest apte à générer une séquence d'autotest d'entrée, une mémoire comprenant une séquence d'autotest attendue en sortie de chaque bloc et une unité de détection d'erreur apte à comparer la séquence obtenue en sortie de chaque bloc logique fonctionnel en injectant en entrée la séquence d'autotest d'entrée avec la séquence d'autotest attendue stockée dans la seconde mémoire.

Selon un mode de réalisation particulier de l'invention, chaque bloc logique fonctionnel comprend en outre un opérateur logique modulo applicable aux données d'entrée et dans lequel les fonctions logiques du bloc logique fonctionnel sont implémentées via une projection sur une composante d'une base RNS.

Selon un mode particulier de réalisation, ledit ensemble comprend en outre un module de cadrage des nombres en entrée de chaque bloc logique fonctionnel afin d'adapter leur dynamique.

Selon un mode particulier de réalisation, ledit ensemble comprend un circuit intégré source, plusieurs circuits intégrés esclaves et un circuit intégré maitre, les différents canaux de traitement étant répartis sur les différents circuits intégrés esclaves.

D'autres caractéristiques et avantages de la présente invention apparaîtront mieux à la lecture de la description qui suit en relation aux dessins annexés suivants.
[Fig. 1] représente un schéma fonctionnel d'un circuit intégré numérique intégrant un mécanisme de protection aux erreurs réversibles selon un premier mode de réalisation de l'invention,
[Fig. 2] représente une variante de réalisation du circuit de la figure 1,
[Fig. 3] représente un schéma fonctionnel d'un canal de traitement du circuit intégré numérique selon le premier mode de réalisation de l'invention,
[Fig. 4] représente un schéma du séquencement des étapes d'une méthode de protection d'un circuit intégré numérique, selon le premier mode de réalisation de l'invention,
[Fig. 5] représente un organigramme des étapes de la méthode décrite à la figure 4,
[Fig. 6] représente un schéma fonctionnel d'un circuit intégré numérique intégrant un mécanisme de protection aux erreurs réversibles selon un deuxième mode de réalisation de l'invention,
[Fig. 7] représente un schéma fonctionnel d'un circuit intégré numérique intégrant un mécanisme de protection aux erreurs réversibles selon un troisième mode de réalisation de l'invention,
[Fig. 8] représente un schéma fonctionnel d'un canal de traitement du circuit intégré numérique selon le deuxième ou le troisième mode de réalisation de l'invention,
[Fig. 9] représente une autre variante de réalisation de l'invention pour laquelle les circuits de traitements sont répartis sur différents circuits intégrés,
[Fig. 10] représente un schéma fonctionnel d'un circuit intégré maître selon la variante représentée à la figure 9.
[Fig. 11] représente un schéma fonctionnel d'un circuit intégré esclave selon la variante représentée à la figure 9,
[Fig. 12] représente un schéma fonctionnel d'un circuit intégré source selon la variante représentée à la figure 9,

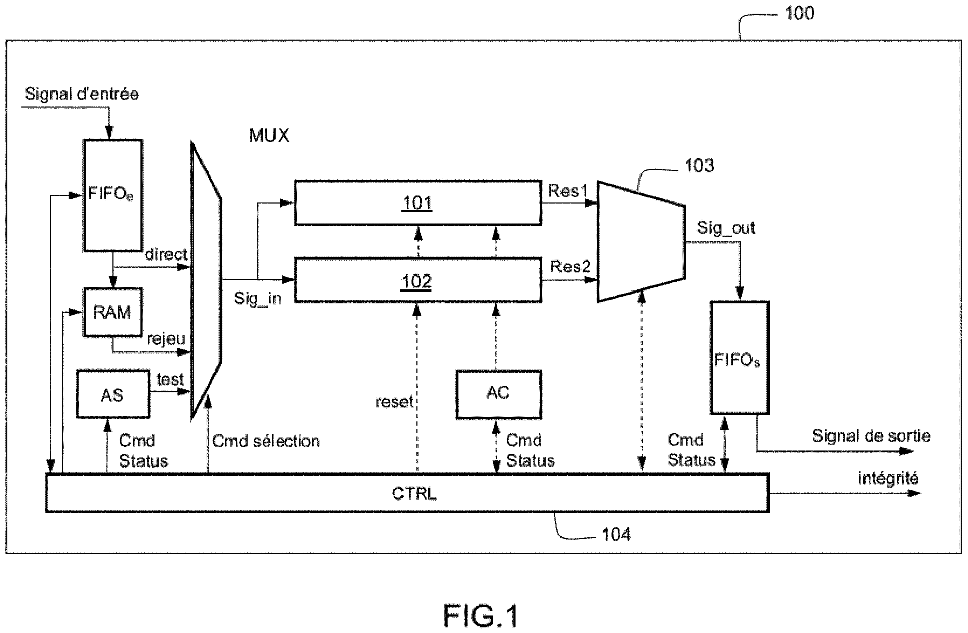

La figure 1 représente un schéma fonctionnel d'un circuit intégré numérique 100 selon un premier mode de réalisation de l'invention. Le circuit 100 comporte principalement deux canaux de traitements 101,102, une unité de détection d'erreur 103 et un contrôleur 104.

Le premier canal de traitement 101 implémente une ou plusieurs fonctions logiques sous la forme d'un bloc logique fonctionnel BLF. Le second canal de traitement 102 est un canal redondant qui implémente une réplique des fonctions logiques du premier canal de traitement 101. Les entrées du circuit 100 sont transmises en parallèle aux deux canaux 101,102.

Les deux canaux de traitement 101,102 implémentent également un mécanisme de re-jeu qui sera explicité par la suite.

L'unité de détection d'erreurs 103 est configurée pour comparer les sorties des deux canaux de traitement 101,102 et détecter une erreur si les deux sorties ne sont pas identiques.

L'unité de détection d'erreurs 103 joue aussi le rôle de multiplexeur pour aiguiller la sortie de l'un des canaux de traitement vers une mémoire FIFO de sortie FIFOₛ. Les sorties du circuit 100 sont lues dans la mémoire FIFOₛ de sortie. En option, une information supplémentaire concernant l'intégrité de la sortie est produite avec la sortie elle-même.

Le contrôleur 104 est configuré pour, en réponse à une erreur détectée par l'unité 103, commander certains mécanismes de détection.

Le circuit 100 comporte aussi une mémoire de configuration (non représentée à la figure 1) qui contient les informations nécessaires à la programmation des ressources logiques de chaque canal de traitement, autrement dit qui permet de programmer les blocs logiques fonctionnels pour qu'ils exécutent une fonction prédéfinie.

Chaque canal de traitement 101,102 comporte un bloc logique fonctionnel BLF réalisant une fonction sensible aux erreurs réversibles. Le bloc logique fonctionnel BLF peut correspondre à une fonction logique élémentaire ou à un ensemble de fonctions logiques interconnectées pour réaliser un traitement particulier. Le bloc logique fonctionnel BLF est programmé à partir de la mémoire de configuration du circuit (non représentée à la figure 1).

Le circuit 100 comporte une mémoire FIFO d'entrée FIFOₑ pour recevoir les données d'entrée du circuit sous forme d'échantillons et alimenter l'entrée du bloc logique fonctionnel BLF de chaque canal de traitement 101,102.

La mémoire FIFO d'entrée et la mémoire FIFO de sortie sont remplies au fil de l'eau selon un principe connu dit du premier entré, premier sorti ou First In First Out en anglais. La mémoire FIFO d'entrée est alimentée par les traitements fonctionnels situés en amont. La mémoire FIFO de sortie fourni des données aux traitements fonctionnels situés en aval.

Le circuit 100 comporte aussi une mémoire tampon, par exemple une mémoire RAM. La mémoire tampon est remplie au fil de l'eau avec les L derniers échantillons lus dans la mémoire FIFO d'entrée, L étant la taille de la mémoire tampon.

Le circuit 100 comporte encore un générateur de stimuli d'autotest AS apte à produire une séquence d'autotest prédéfinie et une unité de contrôle d'autotest AC apte à comparer la sortie du bloc logique fonctionnel avec une séquence attendue pour détecter une erreur. Alternativement, la séquence d'autotest AS peut être stockée dans une mémoire.

Le contrôleur 104 est apte à commander les différents éléments du circuit. En particulier le contrôleur 104 commande l'activité de chaque canal de traitement, l'accès à la lecture dans la mémoire FIFO d'entrée et l'accès à l'écriture dans la mémoire FIFO de sortie. Elle commande aussi l'accès à la lecture dans la mémoire tampon RAM ainsi que l'activité du générateur de stimuli d'autotest AS et de l'unité de contrôle d'autotest AC.

Le circuit 100 comporte encore un multiplexeur MUX contrôlé par le contrôleur 104 pour connecter l'entrée de chaque canal de traitement soit à la sortie de la mémoire FIFO d'entrée, soit à la sortie de la mémoire tampon RAM, soit à la sortie du générateur de stimuli d'autotest AS.

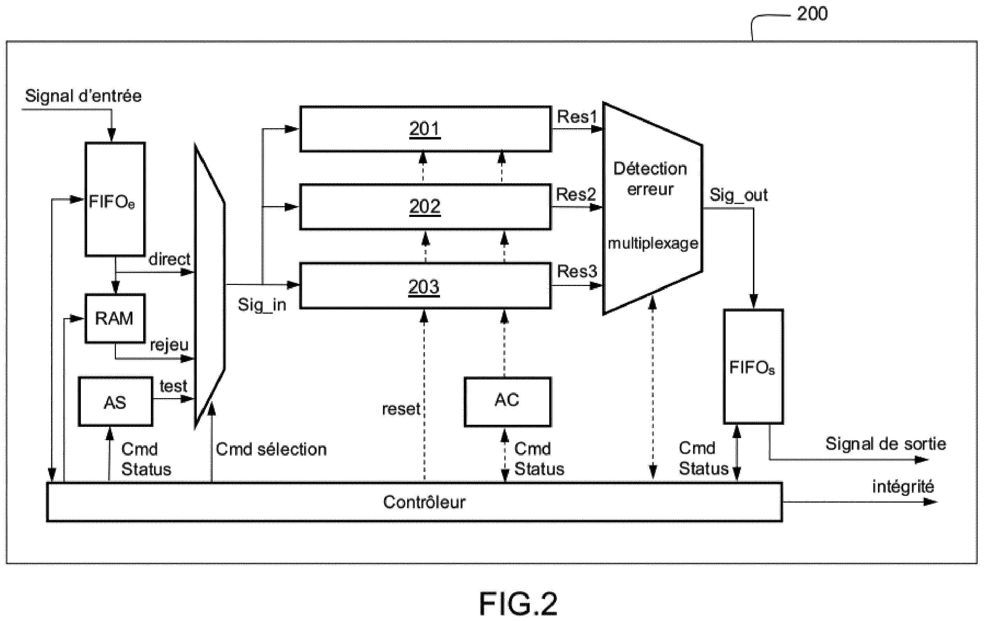

La figure 2 représente une variante de réalisation du circuit de la figure 1 pour laquelle le circuit 200 comporte trois canaux de traitements 201,202,203. De façon générale, le nombre de canaux de traitements opérant en parallèle est un nombre N entier au moins égal à 2.

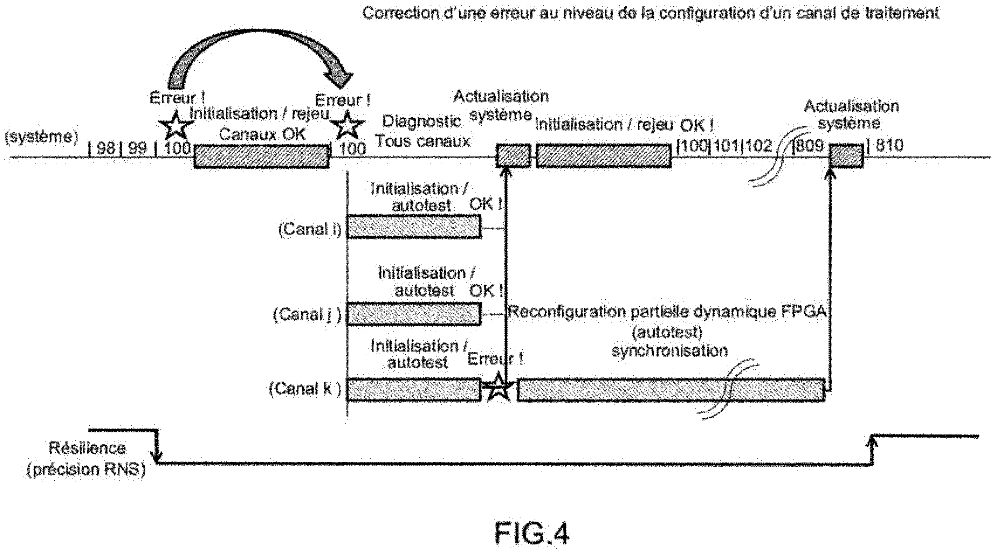

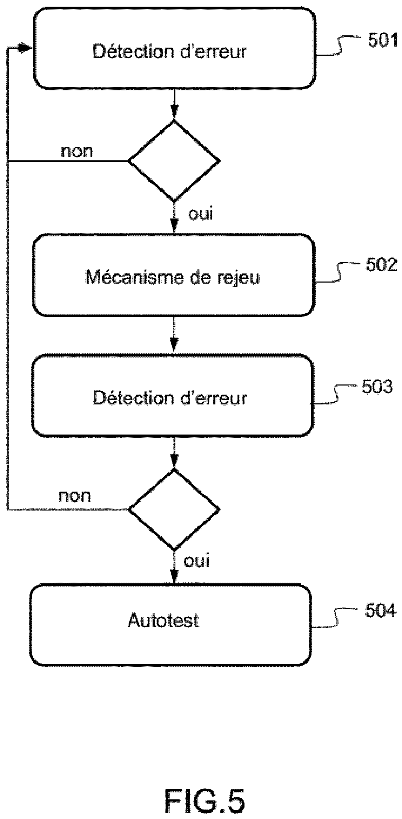

Les figures 4 et 5 décrivent le déroulement de la méthode de protection selon l'invention à un circuit du type des figures 1 ou 2 comprenant N canaux de traitement.

La première étape 501 de la méthode consiste à activer l'unité de détection d'erreurs 103 afin de comparer les sorties des canaux de traitement et de détecter une erreur si ces sorties sont différentes. Cette étape consiste en une approche par redondance qui permet de détecter une erreur dans l'un des canaux de traitement sans connaitre lequel ni connaitre son origine et quelle fonctionnalité l'erreur a impacté. En particulier l'erreur peut concerner l'état interne du bloc logique fonctionnel BLF (mémoires, registres) ou concerner le contenu de la mémoire de configuration qui définit la fonctionnalité mise en œuvre.

Pour identifier l'origine de l'erreur, la méthode consiste ensuite à traiter séparément le cas d'une erreur impactant le bloc logique fonctionnel BLF ou la mémoire de configuration.

Si aucune erreur n'est détectée, la méthode reboucle à l'étape 501 pour surveiller en continu l'apparition de différences entre les sorties des différents canaux de traitement considérés opérationnels.

Si une erreur est détectée, alors la méthode se poursuit à l'étape 502 avec l'exécution d'un mécanisme de re-jeu de données pour chaque canal de traitement opérationnel.

Ce mécanisme consiste à activer la lecture dans la mémoire tampon RAM des L derniers échantillons sauvegardés dans cette mémoire afin de les ré-injecter en entrée du bloc logique fonctionnel BLF de chaque canal de traitement opérationnel et de ré-exécuter la fonctionnalité implémentée pour ces échantillons.

Ce mécanisme peut être implémenté en suivant les enseignements de la demande de brevet FR 3065601 du Demandeur.

Lorsqu'une erreur est détectée, le contrôleur 104 interdit provisoirement l'écriture dans la mémoire FIFO de sortie FIFOₛ, interdit provisoirement la lecture dans la mémoire FIFO d'entrée FIFOₑ, réinitialise le bloc logique fonctionnel BLF de chaque canal de traitement, puis commande l'accès en lecture de la mémoire tampon RAM pour fournir une séquence d'échantillons, antérieurs à l'erreur, en entrée de chaque canal de traitement afin de restaurer l'état logique des canaux. Le basculement de l'entrée des canaux de la mémoire FIFO d'entrée FIFOₑ vers la mémoire tampon RAM peut être réalisé au moyen d'un multiplexeur MUX ou tout autre moyen équivalent. Chaque bloc logique fonctionnel BLF exécute ensuite son traitement sur les données lues dans la mémoire tampon RAM qui sont identiques aux données déjà traitées antérieurement et qui ont conduit à un résultat erroné du fait d'une erreur transitoire. Sur commande du contrôleur, la mémoire tampon RAM cesse d'enregistrer les échantillons lus dans la mémoire FIFO d'entrée FIFOₑ tant que l'état interne du bloc fonctionnel BLF n'a pas été complètement restauré.

En fonctionnement nominal, c'est-à-dire lorsqu'aucune erreur n'est détectée, les échantillons sont lus directement dans la mémoire FIFO d'entrée. En parallèle, les L derniers échantillons lus dans la mémoire FIFO d'entrée sont à chaque instant stockés dans la mémoire tampon RAM qui est reliée à la mémoire FIFO d'entrée. La taille L de la mémoire tampon RAM est directement liée à la latence du bloc logique fonctionnel BLF. Elle est au moins égale à cette latence, exprimée en nombre d'échantillons. En effet, le rôle de la mémoire tampon RAM est de conserver, à chaque instant, les L derniers échantillons lus dans la mémoire FIFO d'entrée pour permettre une restauration de l'état interne du bloc logique fonctionnel BLF et un re-jeu de la fonction réalisée par le bloc logique fonctionnel BLF sur ces L derniers échantillons si une erreur réversible se produit. Le terme « re-jeu » est employé pour désigner une nouvelle exécution du traitement opéré par un bloc logique fonctionnel sur les mêmes échantillons que lors de la séquence précédente.

Le design d'un circuit protégé selon l'invention est constitué de deux domaines d'horloge distincts.

La mémoire FIFO d'entrée et la mémoire FIFO de sortie sont des mémoires synchrones à double ports et double horloges aussi désignés par l'acronyme anglais « dual-clock FIFO » qui sont interfacées entre les deux domaines d'horloge. Autrement dit, chaque mémoire FIFO à un port d'entrée associé à une première horloge et un port de sortie associé à une seconde horloge. Cela permet de découpler le rythme des données entre le domaine d'horloge externe et le domaine d'horloge interne accéléré. Le domaine d'horloge externe correspond aux interfaces d'entrée et de sortie du système protégé. Le domaine d'horloge interne correspond à la logique interne s'interfaçant avec la FIFO d'entrée FIFOₑ et la FIFO de sortie FIFOₛ.

Les autres éléments du circuit protégé sont cadencés à un rythme plus rapide que le rythme moyen nominal de fonctionnement des interfaces d'entrée et de sortie du circuit, relevant du domaine d'horloge externe.

L'accélération du rythme de fonctionnement du système de protection permet de compenser le retard induit par les traitements supplémentaires nécessaires à la correction d'erreur afin de conserver un fonctionnement sans erreur au rythme moyen nominal tel qu'observable aux interfaces de sortie du système protégé.

L'Homme du métier peut se référer à la demande de brevet FR 3065601 pour plus de détails sur le séquencement des traitements lors de l'exécution du mécanisme de re-jeu afin d'assurer une continuité de service.

La méthode se poursuit ensuite avec une nouvelle étape de détection d'erreur 503 par comparaison des sorties des canaux de traitement.

Si toutes les sorties sont identiques et qu'aucune erreur n'est détectée, cela signifie que l'erreur était transitoire et n'a impacté que l'état interne d'un bloc logique fonctionnel.

Si au contraire une erreur est à nouveau détectée, alors cela signifie qu'elle impacte la mémoire de configuration du circuit.

Dans ce cas, la méthode se poursuit avec une étape 504 d'exécution d'un autotest pour chaque canal de traitement.

Le mécanisme d'autotest consiste à suspendre le traitement nominal réalisé par les canaux de traitement en interrompant la lecture dans la mémoire FIFO d'entrée FIFOₑ et l'écriture dans la mémoire FIFO de sortie FIFOₛ.

Le contrôleur 104 active ensuite la production par le générateur de stimuli d'autotest d'une séquence d'autotest et commande le multiplexeur MUX pour que cette séquence soit fournie en entrée des blocs logiques fonctionnels. La séquence d'autotest est une séquence de test prédéfinie stockée dans une mémoire AS ou générée à partir d'un circuit générant un signal déterministe.

Le contrôleur 104 active aussi l'aiguillage de la sortie de chaque bloc logique fonctionnel BLF vers l'unité de contrôle d'autotest AC qui compare cette sortie avec une séquence attendue tabulée dans une mémoire. La séquence attendue prend en compte la configuration souhaitée du bloc logique fonctionnel BLF, c'est-à-dire la configuration obtenue par une programmation à partir de la mémoire de configuration supposée sans erreurs.

Le mécanisme d'autotest permet ainsi de détecter si une erreur a impacté la mémoire de configuration pour chaque canal de traitement de façon indépendante.

Sur le schéma de la figure 4, on a représenté le séquencement temporel des étapes de la méthode selon l'invention. A la réception de l'échantillon numéro 100, l'unité de détection d'erreurs 103 détecte une erreur et une étape de re-jeu 502 est activée pour tous les canaux. A l'issue de cette étape, une erreur est à nouveau détectée sur l'échantillon numéro 100 par l'unité de détection d'erreurs 103. Un diagnostic de tous les canaux est alors enclenché via un autotest indépendant sur chaque canal.

A l'issue de cette étape, les canaux i et j sont déclarés sans erreur et peuvent être conservés pour exécuter le traitement nominal, par contre l'autotest réalisé sur le canal k permet d'identifier une erreur. Pour le canal k, une reconfiguration partielle dynamique de la mémoire de configuration, limitée à ce canal, est réalisée. Pendant cette reconfiguration, le système est actualisé pour prendre en compte le fait que le canal k est hors de service temporairement. Un mécanisme de rejeu est activé sur les canaux i et j afin de reprendre l'exécution du traitement nominal, jusqu'à l'échantillon numéro 100, puis la lecture dans la mémoire FIFO d'entrée est à nouveau activée sur ces canaux i et j.

Lorsque la reconfiguration de la mémoire de configuration est terminée (au niveau de l'échantillon 809 sur l'exemple de la figure 4), le système est actualisé pour prendre en compte le fait que le canal k est à nouveau opérationnel. Une synchronisation temporelle est réalisée pour que le traitement effectué par le canal k soit synchrone de ceux effectués par les autres canaux i et j.

Dans une variante de réalisation de la méthode décrite aux figures 4 et 5, les étapes 502 d'exécution d'un mécanisme de re-jeu et 503 de détection d'erreur sont supprimées. Dans ce cas, l'étape 504 d'exécution d'un mécanisme d'autotest pour chaque canal de traitement est directement réalisée lorsqu'une erreur est détectée à l'issue de la première étape de détection d'erreur 501. Si l'autotest détecte une erreur, alors cela signifie que l'erreur impacte la partie de la mémoire de configuration associée au canal de traitement qui doit être reconfigurée. Si l'autotest ne détecte aucune erreur, alors on exécute ensuite le mécanisme de rejeu de données pour le canal de traitement associé. Un avantage de cette variante est qu'elle permet de traiter en premier lieu les erreurs impactant la mémoire de configuration du circuit et en second lieu les erreurs transitoires.

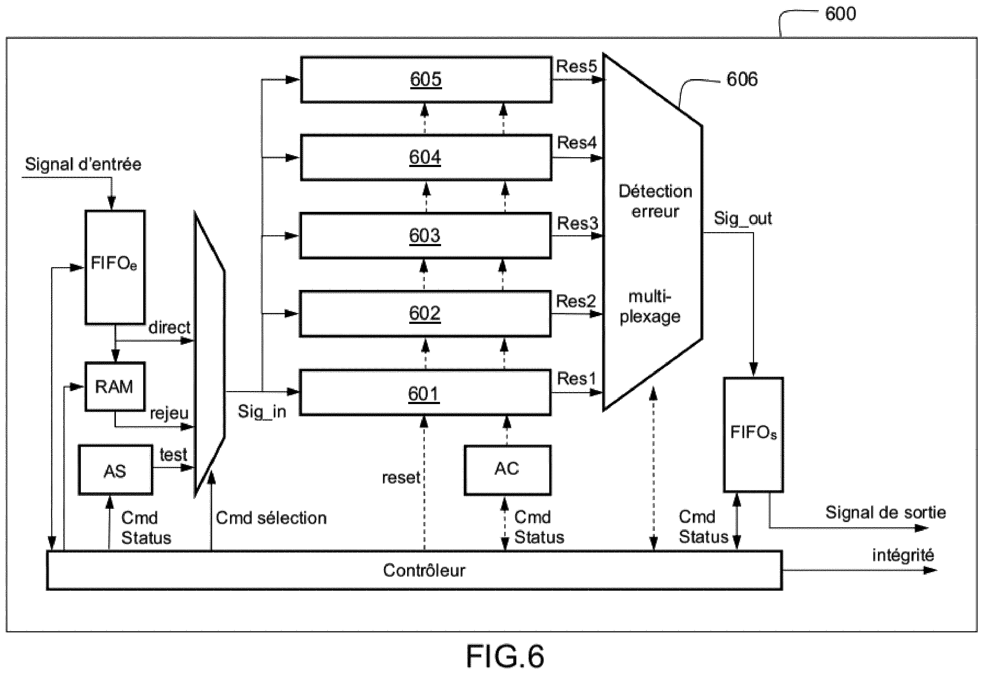

La figure 6 schématise un deuxième mode de réalisation d'un circuit 600 selon l'invention dans lequel les données d'entrée du circuit sont codées en utilisant un système modulaire et redondant de représentation des nombres par résidus ou « Redundant Residue Number System » RRNS en anglais.

Le système modulaire de représentation des nombres par résidus ou système RNS est un outil mathématique utilisé pour vectoriser les données propagées dans un circuit afin de réduire la complexité des calculs. En effet, cette méthode de représentation permet de réduire des calculs sur de grandes valeurs à des calculs menés en parallèle sur des nombres de taille réduite choisie.

L'Homme du métier peut se référer aux documents [1], [2] et [3] pour des détails sur la mise en œuvre des techniques RNS ou RRNS.

Un système modulaire de représentation est défini par une base RNS de plusieurs nombres entiers mutuellement premiers entre eux, dits modules. Par exemple le triplet {3,5,7} est une base RNS. Plus généralement, on note {m₁,m₂,...mₙ} une base RNS et M le produit des modules mᵢ de la base. Tout entier X positif et inférieur à M peut être représenté de manière unique dans cette base RNS par le n-uplet {x₁,...xₙ} avec xᵢ= X mod mᵢ, mod désignant la fonction modulo. Chaque module permet de former une composante RNS d'un nombre.

Cette représentation est utilisée dans le mode de réalisation de l'invention décrit à la figure 6. Chaque donnée X d'entrée est décomposée sur une base RNS et chaque élément xᵢ de cette décomposition est fourni en entrée d'un canal de traitement distinct. Sur l'exemple de la figure 6, on a représenté 5 canaux de traitements 601,605, mais le nombre de canaux est un entier N au moins égal à 2.

Par ailleurs, il est possible d'élargir la base RNS {m₁,m₂,...mₚ} avec des composantes supplémentaires pour former une base étendue RRNS {m₁,m₂,...mₚ,mₚ₊₁,...mₚ₊ₜ}. Dans ce cas, on a p modules principaux et t modules supplémentaires. Les t modules supplémentaires mₚ₊₁,...mₚ₊ₜ doivent être supérieurs à ceux de la base initiale {m₁,m₂,...mₚ}.

Dans une telle base RRNS, il est toujours possible de décoder un nombre X positif et inférieur au produit M des modules principaux, à partir de seulement p composantes quelconques parmi les p+t composantes de la base redondante.

Ce principe est utilisé par l'invention pour disposer de p canaux de traitement principaux 601,602,603 et de t canaux de traitement redondants 604,605. Dans l'exemple de la figure 6, p=3 et t=2.

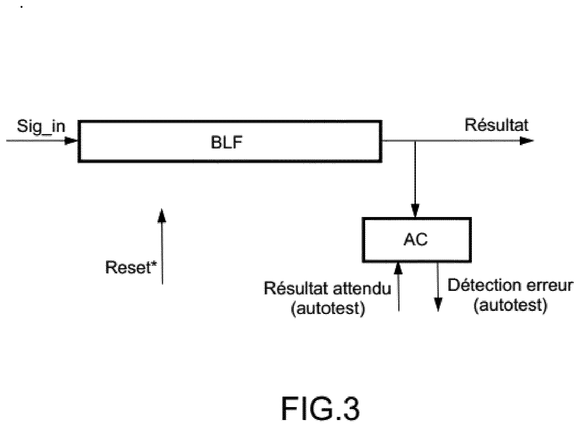

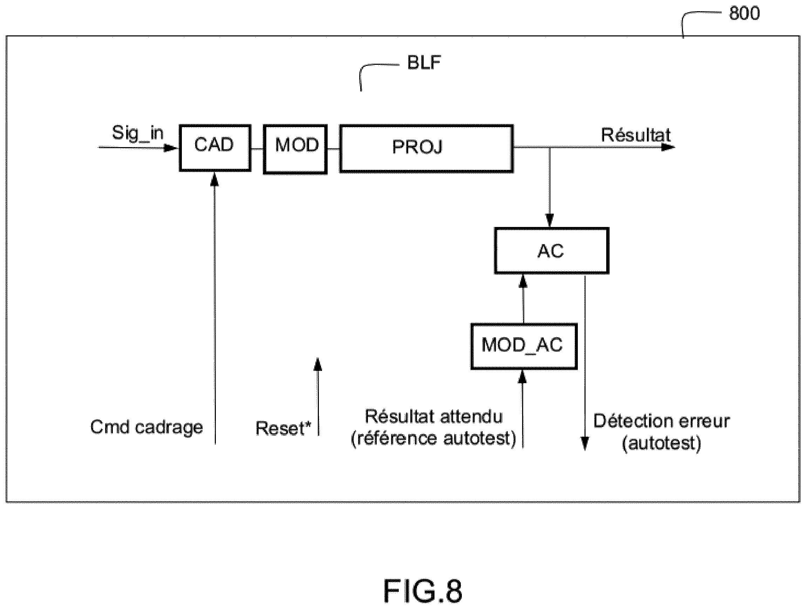

La figure 8 représente une variante de réalisation d'un canal de traitement compatible avec le second mode de réalisation de l'invention. En plus des éléments déjà décrits pour la figure 3, le canal de traitement 800 de la figure 8 comporte un bloc logique fonctionnel BLF qui implémente une fonction modulo mᵢ MOD appliquée aux données d'entrée, avec mᵢ une des composantes de la base RNS, chaque canal de traitement utilisant une composante différente. Par ailleurs la ou les fonction(s) logique(s) élémentaire(s) implémentées sont projetées modulo la composante mᵢ. Autrement dit, cela signifie que les opérations réalisées sont adaptées au format réduit des nombres. L'implémentation de cette projection est notée PROJ sur la figure 8.

L'unité de détection d'erreurs 606 réalise une détection d'erreurs à partir de l'ensemble des sorties des différents canaux de traitement 601-605 en deux étapes selon une technique connue décrite dans les documents [1-3]. La première étape consiste à décoder le nombre X à partir de ses composantes dans la base RNS redondante obtenues en sortie de chaque canal de traitement. Cette étape de décodage peut être réalisée au moyen d'un algorithme de type théorème des restes chinois ou par une technique dite de « Mixed Radix Conversion » (MRC). Ces deux techniques sont décrites dans le document [3]. D'autres méthodes de décodage sont envisageables sans sortir du cadre de l'invention.

La seconde étape consiste à comparer le nombre décodé X à la dynamique M de la base RNS initiale le : $M = {\prod }_{i = 1}^{p} {m}_{i}$.

Dans l'exemple de la figure 6, les composantes principales sont celles associées aux canaux de traitement 601 à 603.

Par construction, pour toute configuration d'erreur impactant entre une et t composantes RNS du nombre X (c'est-à-dire intervient sur l'un des canaux de traitement quelconque, y compris les canaux redondants 604,605), alors le résultat du décodage du nombre X est forcément supérieur à M. Cette propriété est intrinsèque aux systèmes modulaires de représentation redondants RRNS tel qu'explicité dans le document [2].

Ainsi, par simple comparaison du nombre X avec M, on peut en déduire si une erreur est intervenue sur un sous-ensemble des composantes donc sur un sous-ensemble des canaux de traitement.

La suite des étapes de la méthode de protection selon l'invention s'applique à l'identique (mécanisme de re-jeu et autotest).

L'ajout de canaux de traitement redondants permet d'assurer une continuité de service en maintenant la capacité de correction lorsque l'un des canaux de traitement subit une reconfiguration partielle et est ainsi inopérant pendant une certaine durée. En particulier, l'ajout de t canaux redondants permet de tolérer des erreurs simultanées dans t canaux. En effet, les nombres peuvent être décodés correctement tant que p canaux quelconques sont opérationnels (p= 3 dans l'exemple de la figure 6).

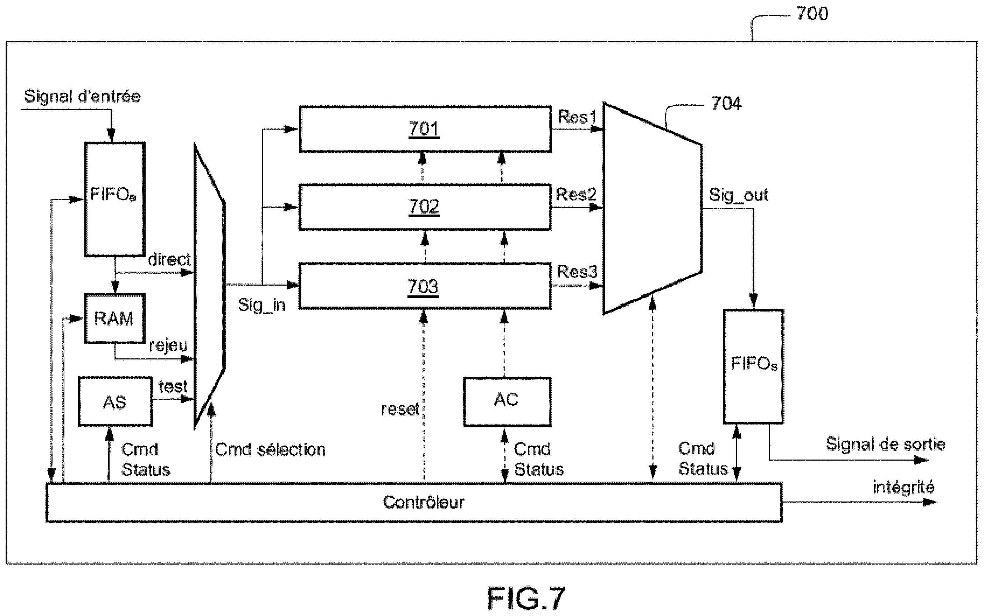

La figure 7 schématise un troisième mode de réalisation du circuit selon l'invention. Ce troisième mode de réalisation s'appuie toujours sur une représentation des nombres dans un système modulaire de représentation, cependant cette fois, le nombre de composantes redondantes (et donc de canaux redondants) n'est pas figé a priori mais peut être adapté en fonction du besoin en capacité de correction, en adaptant la dynamique des nombres en entrée du circuit. Par exemple, dans une première utilisation, aucun canal de traitement redondant n'est prévu, la dynamique des nombres décodables étant égale à $M = {\prod }_{i = 1}^{N} {m}_{i}$, avec N le nombre total de canaux de traitement (N= 3 dans l'exemple de la figure 7). Cette configuration RNS non redondante ne permet pas de détecter d'erreur par comparaison des sorties des canaux de traitement. En mobilisant un module m₃ au titre de la redondance, on forme une base RRNS avec deux modules principaux {m₁, m₂}, ce qui permet de détecter une erreur sur une composante quelconque parmi les trois. Il est également possible d'augmenter dynamiquement la capacité de correction en mobilisant deux modules {m₂, m₃} pour la redondance, mais la dynamique des nombres décodables est réduite à m₁.

Cette configuration permet d'adapter la tolérance aux erreurs moyennant une adaptation de la dynamique des nombres.

Pour mettre en œuvre cette variante de réalisation, chaque canal de traitement 800 doit intégrer un module de cadrage de dynamique (CAD) en entrée du bloc logique fonctionnel BLF (voir figure 8). Ce module est commandé par le contrôleur 104 en fonction de la configuration souhaitée.

L'unité de détection d'erreurs 704 est aussi adaptée pour prendre en compte le nombre t de canaux de traitement redondants afin de configurer le seuil de comparaison pour la détection d'erreurs.

Ainsi, afin de maintenir une capacité de correction, la dynamique des nombres peut être réduite suite à la détection d'une erreur en SRAM de configuration, le temps de reconfigurer le ou les canaux de traitements diagnostiqués inopérants par autotest. Une fois les erreurs corrigées, la dynamique des nombres peut être à nouveau augmentée.

De façon générale ce troisième mode de réalisation permet de réaliser un compromis entre la précision de calcul et le niveau souhaité de tolérance aux erreurs. Il permet également une gestion dynamique de ce compromis.

L'invention est applicable à un circuit intégré numérique reconfigurable ou à un ensemble de circuits reconfigurables fonctionnant ensemble comme un unique circuit. Dans ce cas, les unités de détection d'erreur et les unités de contrôle des différents circuits sont interfacées afin de partager des informations pour coordonner l'ensemble des canaux de traitements répartis sur les différents circuits.

En particulier, dans une variante de réalisation, les canaux de traitements sont répartis sur un ensemble d'au moins deux circuits intégrés numériques reconfigurables esclaves connectés à un circuit maitre.

De manière générale, le fonctionnement est identique au cas de la protection d'un unique circuit intégré, avec les mêmes fonctions et mécanismes, répartis et répliqués dans différents circuits intégrés.

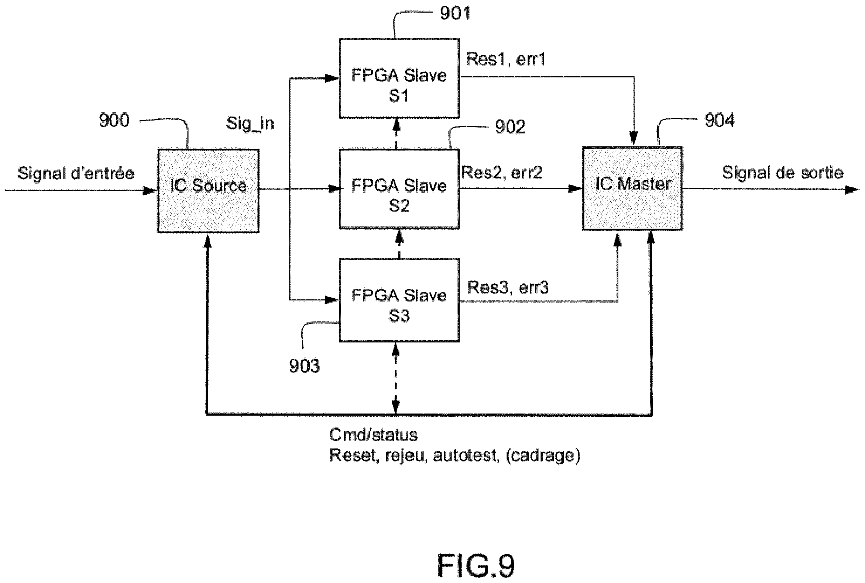

Les figures 9,10,11 et 12 représentent un exemple de réalisation de cette variante.

La figure 9 illustre un schéma d'un ensemble de circuits intégrés reconfigurables comprenant un circuit source 900, plusieurs circuits esclaves 901,902,903 et un circuit maitre 904. Les canaux de traitement sont répartis sur les différents circuits esclaves 901,902,903.

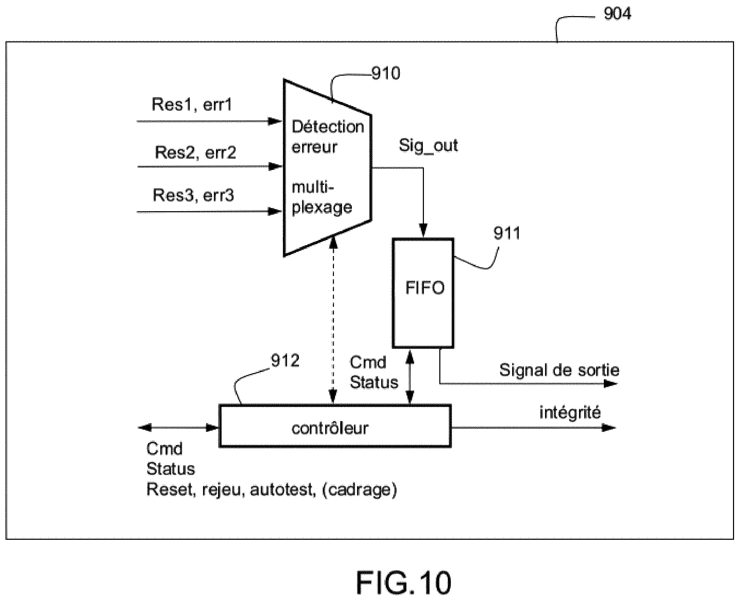

La figure 10 représente un schéma d'un circuit maitre 904. Le circuit maitre 904 intègre un contrôleur principal 912, un module de multiplexage et de détection d'erreur 910 pour prendre en compte les résultats de tous les circuits esclaves 901,902,903, une mémoire FIFO de sortie 911 pour stocker les résultats validés et pour réaliser le découplage entre le rythme de traitement local et le rythme de propagation des données vers la logique en aval. La détection d'erreur est réalisée comme dans le cas d'un circuit numérique en reconstruisant le nombre X à partir des résultats partiels res1,res2,res3 produits par les circuits esclaves.

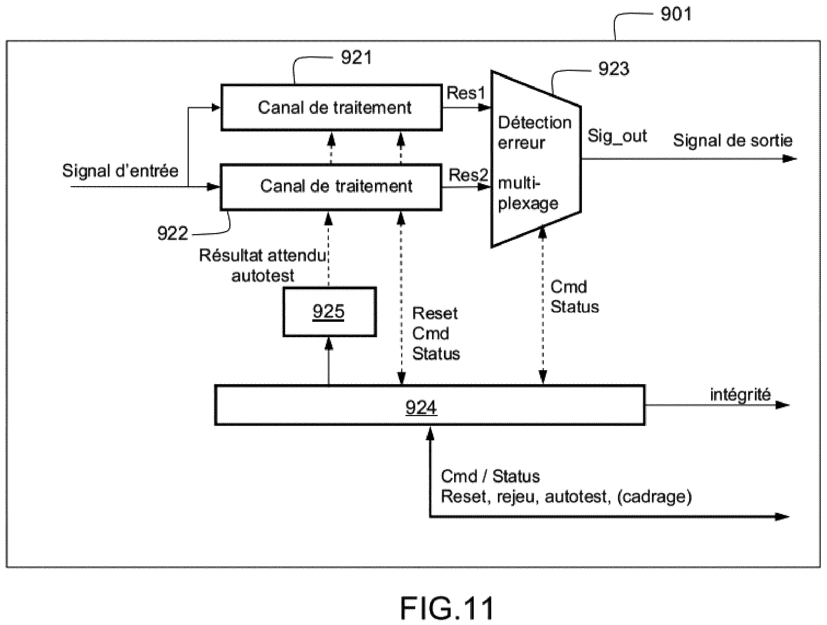

La figure 11 représente un schéma d'un circuit esclave 901. Le circuit intégré esclave 901 comporte un sous-ensemble des canaux de traitement 921,922, ainsi qu'un module de multiplexage et de détection d'erreur 923 par comparaison des sorties de ces canaux, un contrôleur local 924 pour piloter les canaux de traitements et le module de multiplexage et détection d'erreur. Ce contrôleur local 924 est lui-même piloté par le contrôleur principal 912 du circuit maitre 904 coordonnant le fonctionnement des circuits esclaves. Le circuit intégré esclave 901 comporte encore une unité de contrôle d'autotest 925 qui peut être intégrée directement dans chaque canal de traitement en variante. Dans le cas d'un circuit esclave implantant un unique canal de traitement, le module de multiplexage et de détection d'erreur 923 n'est pas utile.

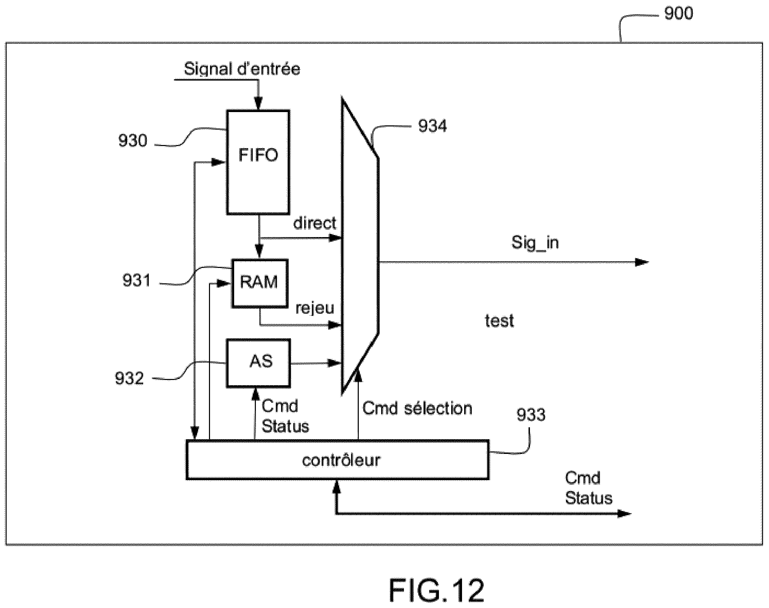

La figure 12 représente un schéma du circuit source 900. Il comporte une mémoire FIFO d'entrée 930, une mémoire RAM 931, un générateur de stimuli d'autotest 932, un contrôleur local 933 et un multiplexeur 934.

De façon générale les différents éléments du circuit intégré protégé selon l'invention tel que décrit pour un circuit unique sont identiques pour une application à plusieurs circuits intégrés, ces éléments étant répartis sur les différents circuits (source, esclave et maitre) tel qu'indiqué aux figures 10,11 et 12.

L'invention procure notamment les avantages techniques suivants par rapport aux solutions de l'art antérieur.

Elle permet une protection contre l'effet des erreurs à la fois au niveau de la logique des fonctions implémentées par le circuit reconfigurable mais aussi au niveau du contenu de la mémoire de configuration et ce sans interruption de service.

Les mécanismes de correction ne sont déclenchés que lorsque cela est nécessaire c'est-à-dire lorsqu'une incohérence est détectée sur les sorties des canaux de traitement opérationnels.

Les mécanismes mis en œuvre sont rapides notamment car ils permettent de ne reconfigurer que les canaux de traitement dont la configuration a été impactée par une erreur et de conserver une continuité de service grâce aux autres canaux de traitement opérationnels.

L'invention présente une faible complexité logique pour un niveau donné de résilience. En particulier, le troisième mode de réalisation de l'invention permet d'adapter la capacité de correction à travers la proportion des ressources affectées à la redondance pour la détection d'erreur (canaux de traitement redondants), en adaptant la dynamique RNS.

### Références

[1] "RNS Representations with Redundant Residues, Behrooz Parhami"
[2] "Redundant Residue number systems for error detection and correction in digital filters, Mark H. Etzel et al."
[3] "Error Correction based on redundant residue number system, Jilu James et al"

## Revendications

1. Méthode de protection, contre les erreurs réversibles, d'un circuit intégré numérique reconfigurable au moyen d'une mémoire de configuration, le circuit intégré numérique comprenant plusieurs canaux de traitement parallèles comprenant chacun une instance d'un bloc logique fonctionnel et une unité de détection d'erreur à partir des sorties des canaux de traitement, le circuit implémentant un mécanisme de rejeu de données consistant en une nouvelle exécution d'un bloc logique fonctionnel sur les mêmes échantillons de données qu'une exécution antérieure du même bloc et un mécanisme d'autotest, la méthode comprenant une première étape de :
- Activer (501) l'unité de détection d'erreur pour détecter une erreur dans au moins un canal de traitement,
la méthode étant **caractérisée en ce qu'**elle comporte en outre les étapes successives de :
- Si une erreur est détectée par l'unité de détection d'erreur, exécuter (504) un autotest sur chaque canal de traitement consistant à :
i. Interrompre le fonctionnement nominal du canal de traitement,
ii. Exécuter le bloc logique fonctionnel pour des données d'autotest générées par le mécanisme d'autotest,
iii. Comparer la sortie du bloc logique fonctionnel avec des données prédéfinies correspondant à un fonctionnement attendu du canal de traitement.
- Pour chaque canal de traitement,
i. Si l'autotest ne détecte aucune erreur, exécuter le mécanisme de rejeu de données pour ce canal de traitement,
ii. Si l'autotest détecte une erreur, reconfigurer au moins la partie de la mémoire de configuration associée à ce canal de traitement.

2. Méthode de protection d'un circuit intégré numérique selon la revendication 1 comprenant en outre les étapes suivantes exécutées immédiatement après la première étape d'activer (501) l'unité de détection d'erreur :
- en réponse à une erreur détectée par l'unité de détection d'erreur dans au moins un canal de traitement, exécuter (502) le mécanisme de rejeu de données pour chaque canal de traitement, puis
- activer (503) l'unité de détection d'erreur pour détecter une erreur dans au moins un canal de traitement,

3. Méthode de protection d'un circuit intégré numérique selon l'une quelconque des revendications précédentes dans lequel l'étape d'exécuter le mécanisme de rejeu de données comprend les sous- étapes de :
- réinitialiser le bloc logique fonctionnel,
- exécuter, à un rythme supérieur au rythme nominal d'exécution du circuit intégré, le bloc logique fonctionnel pour des données antérieures sauvegardées dans une mémoire tampon.

4. Méthode de protection d'un circuit intégré numérique selon l'une quelconque des revendications précédentes comprenant en outre une étape de synchronisation, après reconfiguration, du canal de traitement pour lequel une erreur a été détectée par l'autotest avec les autres canaux de traitements.

5. Méthode de protection d'un circuit intégré numérique selon l'une quelconque des revendications précédentes dans laquelle l'étape de détecter une erreur dans au moins un canal de traitement consiste au moins à comparer les sorties de tous les canaux de traitement et à déclarer la présence d'une erreur si toutes les sorties ne sont pas identiques.

6. Méthode de protection d'un circuit intégré numérique selon l'une quelconque des revendications 1 à 4 dans laquelle les nombres traités par le circuit intégré numérique sont codés selon un système modulaire de représentation par les résidus dit RNS dans lequel les nombres sont exprimés dans une base de représentation RNS définie par une pluralité de modules mutuellement premiers entre eux, un nombre étant codé par un vecteur dont chaque composante correspond au modulo du nombre par un module de la base RNS, chaque canal de traitement étant destiné à traiter une composante et l'ensemble des canaux de traitement comprenant au moins un canal associé à une composante redondante.

7. Méthode de protection d'un circuit intégré numérique selon la revendication 6 dans laquelle l'étape de détecter une erreur dans au moins un canal de traitement consiste au moins à :
- Convertir les composantes en sortie de l'ensemble des canaux de traitements en un nombre,
- Détecter une erreur si ce nombre dépasse la dynamique de la base RNS sans redondance.

8. Méthode de protection d'un circuit intégré numérique selon l'une quelconque des revendications 6 ou 7 dans laquelle la dynamique d'entrée des nombres traités par le circuit intégré numérique est adaptable de manière à associer indistinctement au moins un canal de traitement à une composante redondante.

9. Ensemble d'au moins un circuit intégré numérique (100,200,600,700) reconfigurable comprenant plusieurs canaux de traitement parallèles (101,102,601,602,603,604,605) comprenant chacun une instance d'un bloc logique fonctionnel (BLF), une mémoire de configuration de l'au moins un circuit, une unité de détection d'erreur (103,606,704) à partir des sorties des canaux de traitement et un contrôleur (104), chaque circuit implémentant un mécanisme de re-jeu de données et un mécanisme d'autotest des canaux de traitement, le contrôleur (104) étant configuré pour commander les éléments de l'au moins un circuit intégré numérique de manière à implémenter une méthode de protection contre les erreurs réversibles selon l'une quelconque des revendications précédentes.

10. Ensemble d'au moins un circuit intégré numérique selon la revendication 9 comprenant une mémoire FIFO d'entrée (FIFOₑ) pour alimenter en échantillons chaque canal de traitement, une mémoire FIFO de sortie (FIFOₛ) pour recevoir des échantillons provenant de l'unité de détection d'erreur, une mémoire tampon (RAM) alimentée en échantillons par la mémoire FIFO d'entrée (FIFOₑ), le contrôleur (104) étant apte à commander l'accès en lecture dans la mémoire FIFO d'entrée (FIFOₑ) et l'accès en écriture dans la mémoire FIFO de sortie (FIFOₛ) et étant configuré pour exécuter un mécanisme de rejeu consistant à réinitialiser chaque bloc logique fonctionnel (BLF), suspendre l'accès en lecture dans la mémoire FIFO d'entrée (FIFOₑ), suspendre l'accès en écriture dans la mémoire FIFO de sortie (FIFOₛ) et basculer l'entrée des canaux de traitements vers la sortie de la mémoire tampon (RAM).

11. Ensemble d'au moins un circuit intégré numérique selon l'une quelconque des revendications 9 ou 10 comprenant en outre un générateur de stimuli d'autotest (AS) apte à générer une séquence d'autotest d'entrée, une mémoire comprenant une séquence d'autotest attendue en sortie de chaque bloc (BLF) et une unité de détection d'erreur (AC) apte à comparer la séquence obtenue en sortie de chaque bloc logique fonctionnel (BLF) en injectant en entrée la séquence d'autotest d'entrée avec la séquence d'autotest attendue stockée dans la seconde mémoire.

12. Ensemble d'au moins un circuit intégré numérique selon l'une quelconque des revendications 9 à 11 dans lequel chaque bloc logique fonctionnel (BLF) comprend en outre un opérateur logique modulo (MOD) applicable aux données d'entrée et dans lequel les fonctions logiques du bloc logique fonctionnel sont implémentées via une projection (PROJ) sur une composante d'une base RNS.

13. Ensemble d'au moins un circuit intégré numérique selon la revendication 12 comprenant en outre un module de cadrage (CAD) des nombres en entrée de chaque bloc logique fonctionnel (BLF) afin d'adapter leur dynamique.

14. Ensemble d'au moins un circuit intégré numérique selon l'une quelconque des revendications 9 à 13 comprenant un circuit intégré source, plusieurs circuits intégrés esclaves et un circuit intégré maitre, les différents canaux de traitement étant répartis sur les différents circuits intégrés esclaves.

## Patentansprüche

1. Verfahren zum Schutz einer rekonfigurierbaren digitalen integrierten Schaltung vor reversiblen Fehlern mittels eines Konfigurationsspeichers, wobei die digitale integrierte Schaltung mehrere parallele Verarbeitungskanäle, die jeweils eine Instanz eines funktionalen Logikblocks umfassen, und eine Einheit zur Fehlererkennung auf Grundlage der Ausgänge der Verarbeitungskanäle umfasst, wobei die Schaltung einen Data-Replay-Mechanismus, der in einer erneuten Ausführung eines funktionalen Logikblocks an denselben Datenstichproben wie bei einer früheren Ausführung desselben Blocks besteht, und einen Selbsttestmechanismus implementiert, wobei das Verfahren den folgenden ersten Schritt umfasst:
- Aktivieren (501) der Fehlererkennungseinheit, um einen Fehler in mindestens einem Verarbeitungskanal zu erkennen,
wobei das Verfahren **dadurch gekennzeichnet ist, dass** es weiter die folgenden, aufeinanderfolgenden Schritte umfasst:
- wenn von der Fehlererkennungseinheit ein Fehler erkannt wird, Ausführen (504) eines Selbsttests auf jedem Verarbeitungskanal, der darin besteht:
i. den Nennbetrieb des Verarbeitungskanals zu unterbrechen,
ii. den funktionalen Logikblock für Selbsttestdaten auszuführen, die von dem Selbsttestmechanismus erzeugt werden,
iii. den Ausgang des funktionalen Logikblocks mit vordefinierten Daten zu vergleichen, die einer erwarteten Funktion des Verarbeitungskanals entsprechen.
- für jeden Verarbeitungskanal
i. wenn der Selbsttest keinen Fehler erkennt, den Data-Replay-Mechanismus für diesen Verarbeitungskanal auszuführen,
ii. wenn der Selbsttest einen Fehler erkennt, mindestens den Teil des Konfigurationsspeichers, der diesem Verarbeitungskanal zugeordnet ist, zu rekonfigurieren.

2. Verfahren zum Schutz einer digitalen integrierten Schaltung nach Anspruch 1, das weiter die folgenden Schritte umfasst, die unmittelbar nach dem ersten Schritt des Aktivierens (501) der Fehlererkennungseinheit ausgeführt werden:
- in Reaktion auf einen von der Fehlererkennungseinheit in mindestens einem Verarbeitungskanal erkannten Fehler, Ausführen (502) des Data-Replay-Mechanismus für jeden Verarbeitungskanal, und anschließend
- Aktivieren (503) der Fehlererkennungseinheit, um einen Fehler in mindestens einem Verarbeitungskanal zu erkennen,

3. Verfahren zum Schutz einer digitalen integrierten Schaltung nach einem der vorstehenden Ansprüche, wobei der Schritt des Ausführens des Data-Replay-Mechanismus die folgenden Teilschritte umfasst:
- Zurücksetzen des funktionalen Logikblocks,
- Ausführen des funktionalen Logikblocks mit einer höheren Taktrate als der Nenn-Ausführungstaktrate der integrierten Schaltung für frühere, in einem Pufferspeicher gespeicherte Daten.

4. Verfahren zum Schutz einer digitalen integrierten Schaltung nach einem der vorstehenden Ansprüche, das nach der Rekonfiguration weiter einen Schritt des Synchronisierens des Verarbeitungskanals, bei dem durch den Selbsttest ein Fehler erkannt wurde, mit den anderen Verarbeitungskanälen umfasst.

5. Verfahren zum Schutz einer digitalen integrierten Schaltung nach einem der vorstehenden Ansprüche, wobei der Schritt des Erkennens eines Fehlers in mindestens einem Verarbeitungskanal mindestens darin besteht, die Ausgänge aller Verarbeitungskanäle zu vergleichen und das Vorliegen eines Fehlers zu vermelden, wenn nicht alle Ausgänge identisch sind.

6. Verfahren zum Schutz einer digitalen integrierten Schaltung nach einem der Ansprüche 1 bis 4, wobei die von der digitalen integrierten Schaltung verarbeiteten Zahlen nach einem modularen Restdarstellungssystem, das als RNS bezeichnet wird, codiert werden, wobei die Zahlen in einer RNS-Darstellungsbasis ausgedrückt werden, die durch eine Vielzahl von zueinander teilerfremden Modulen definiert ist, wobei eine Zahl durch einen Vektor codiert wird, von dem jede Komponente dem Modulo der Zahl durch ein Modul der RNS-Basis entspricht, wobei jeder Verarbeitungskanal dazu bestimmt ist, eine Komponente zu verarbeiten, und die Gesamtheit der Verarbeitungskanäle mindestens einen Kanal umfasst, der einer redundanten Komponente zugeordnet ist.

7. Verfahren zum Schutz einer digitalen integrierten Schaltung nach Anspruch 6, wobei der Schritt des Erkennens eines Fehlers in mindestens einem Verarbeitungskanal mindestens darin besteht:
- die Komponenten am Ausgang der Gesamtheit der Verarbeitungskanäle in eine Zahl umzuwandeln,
- einen Fehler zu erkennen, wenn diese Zahl die Dynamik der RNS-Basis ohne Redundanz überschreitet.

8. Verfahren zum Schutz einer digitalen integrierten Schaltung nach einem der Ansprüche 6 oder 7, wobei die Eingangsdynamik der von der digitalen integrierten Schaltung verarbeiteten Zahlen so angepasst werden kann, dass mindestens einem Verarbeitungskanal unterschiedslos eine redundante Komponente zugeordnet wird.

9. Anordnung aus mindestens einer rekonfigurierbaren digitalen integrierten Schaltung (100, 200, 600, 700), die mehrere parallele Verarbeitungskanäle (101, 102, 601, 602, 603, 604, 605) umfasst, von denen jeder eine Instanz eines funktionalen Logikblocks (BLF) umfasst, einem Konfigurationsspeicher für die mindestens eine Schaltung, einer Einheit (103, 606, 704) zur Erkennung von Fehlern auf Grundlage der Ausgänge der Verarbeitungskanäle und einer Steuereinheit (104), wobei jede Schaltung einen Data-Replay-Mechanismus und einen Selbsttestmechanismus der Verarbeitungskanäle implementiert, wobei die Steuereinheit (104) so konfiguriert ist, dass sie die Elemente der mindestens einen digitalen integrierten Schaltung so steuert, dass ein Verfahren zum Schutz vor reversiblen Fehlern nach einem der vorstehenden Ansprüche implementiert wird.

10. Anordnung aus mindestens einer digitalen integrierten Schaltung nach Anspruch 9, die einen FIFO-Eingangsspeicher (FIFOₑ), um jedem Verarbeitungskanal Stichproben zuzuführen, einen FIFO-Ausgangsspeicher (FIFOₛ), um von der Fehlererkennungseinheit stammende Stichproben zu empfangen, einen Pufferspeicher (RAM), dem von dem FIFO-Eingangsspeicher (FIFOₑ) Stichproben zugeführt werden, umfasst, wobei die Steuereinheit (104) in der Lage ist, den Lesezugriff auf den FIFO-Eingangsspeicher (FIFOₑ) und den Schreibzugriff auf den FIFO-Ausgangsspeicher (FIFOₛ) zu steuern, und so konfiguriert ist, dass sie einen Replay-Mechanismus ausführt, der darin besteht, jeden funktionalen Logikblock (BLF) zurückzusetzen, den Lesezugriff auf den FIFO-Eingangsspeicher (FIFOₑ) zu pausieren, den Schreibzugriff auf den FIFO-Ausgangsspeicher (FIFOₛ) zu pausieren und den Eingang der Verarbeitungskanäle auf den Ausgang des Pufferspeichers (RAM) umzuschalten.

11. Anordnung aus mindestens einer digitalen integrierten Schaltung nach einem der Ansprüche 9 oder 10, die weiter einen Selbsttest-Stimulusgenerator (AS), der in der Lage ist, eine Eingangs-Selbsttestsequenz zu erzeugen, einen Speicher, der eine am Ausgang jedes Blocks (BLF) erwartete Selbsttestsequenz umfasst, und eine Fehlererkennungseinheit (AC) umfasst, die in der Lage ist, die am Ausgang jedes funktionalen Logikblocks (BLF) erhaltene Sequenz durch Einspeisen der Eingangs-Selbsttestsequenz in den Eingang mit der im zweiten Speicher gespeicherten erwarteten Selbsttestsequenz zu vergleichen.

12. Anordnung aus mindestens einer digitalen integrierten Schaltung nach einem der Ansprüche 9 bis 11, wobei jeder funktionale Logikblock (BLF) weiter einen auf die Eingangsdaten anwendbaren Modulo-Logikoperator (MOD) umfasst, und wobei die logischen Funktionen des funktionalen Logikblocks über eine Projektion (PROJ) auf eine Komponente einer RNS-Basis implementiert sind.

13. Anordnung aus mindestens einer digitalen integrierten Schaltung nach Anspruch 12, die weiter ein Modul (CAD) zur Cadrage der Zahlen am Eingang jedes funktionalen Logikblocks (BLF) umfasst, um deren Dynamik anzupassen.

14. Anordnung aus mindestens einer digitalen integrierten Schaltung nach einem der Ansprüche 9 bis 13, die eine integrierte Source-Schaltung, mehrere integrierte Slave-Schaltungen und eine integrierte Master-Schaltung umfasst, wobei die verschiedenen Verarbeitungskanäle auf die verschiedenen integrierten Slave-Schaltungen verteilt sind.

## Claims

1. Method for protecting, against reversible errors, a digital integrated circuit reconfigurable by means of a configuration memory, the digital integrated circuit comprising several parallel processing channels each comprising an instance of a functional logic block and an error detection unit operating on the basis of the outputs of the processing channels, the circuit implementing a data replay mechanism consisting of a new execution of a functional logic block on the same data samples as a previous execution of the same block and a self-test mechanism, the method comprising a first step of:
- Activating (501) the error detection unit to detect an error in at least one processing channel,
the method being **characterized in that** it further comprises the successive steps of:
- If an error is detected by the error detection unit, executing (504) a self-test on each processing channel consisting of:
i. Interrupting the nominal operation of the processing channel,
ii. Executing the functional logic block for self-test data generated by the self-test mechanism,
iii. Comparing the output of the functional logic block with predefined data corresponding to an expected operation of the processing channel.
- For each processing channel,
i. If the self-test does not detect any error, executing the data replay mechanism for this processing channel,
ii. If the self-test detects an error, reconfiguring at least the part of the configuration memory associated with this processing channel.

2. Method for protecting a digital integrated circuit according to claim 1, further comprising the following steps executed immediately after the first step of activating (501) the error detection unit:
- in response to an error detected by the error detection unit in at least one processing channel, executing (502) the data replay mechanism for each processing channel, then
- activating (503) the error detection unit to detect an error in at least one processing channel,

3. Method for protecting a digital integrated circuit according to any one of the preceding claims, wherein the step of executing the data replay mechanism comprises the substeps of:
- resetting the functional logic block,
- executing, at a rate higher than the nominal execution rate of the integrated circuit, the functional logic block for previous data saved in a buffer memory.

4. Method for protecting a digital integrated circuit according to any one of the preceding claims, further comprising a step of synchronizing, after reconfiguration, the processing channel for which an error has been detected by the self-test with the other processing channels.

5. Method for protecting a digital integrated circuit according to any one of the preceding claims, wherein the step of detecting an error in at least one processing channel consists at least of comparing the outputs of all the processing channels and declaring the presence of an error if the outputs are not all identical.

6. Method for protecting a digital integrated circuit according to any one of claims 1 to 4, wherein the numbers processed by the digital integrated circuit are encoded according to a residue number system referred to as RNS, wherein the numbers are expressed in an RNS representation base defined by a plurality of pairwise relatively prime moduli, a number being encoded by a vector each component of which corresponds to the remainder of the number modulo a modulus of the RNS base, each processing channel being intended to process one component and the set of processing channels comprising at least one channel associated with a redundant component.

7. Method for protecting a digital integrated circuit according to claim 6, wherein the step of detecting an error in at least one processing channel consists at least of:
- Converting the components at the outputs of the set of processing channels into a number,
- Detecting an error if this number exceeds the dynamic range of the RNS base without redundancy.

8. Method for protecting a digital integrated circuit according to any one of claims 6 or 7, wherein the input dynamic range of the numbers processed by the digital integrated circuit is adaptable so as to associate any of the processing channels with a redundant component, with at least one processing channel being so associated..

9. Assembly of at least one reconfigurable digital integrated circuit (100,200,600,700) comprising several parallel processing channels (101,102,601,602,603,604,605) each comprising an instance of a functional logic block (BLF), a configuration memory of the at least one circuit, an error detection unit (103,606,704) operating on the basis of the outputs of the processing channels and a controller (104), each circuit implementing a data replay mechanism and a mechanism for self-testing the processing channels, the controller (104) being configured to control the elements of the at least one digital integrated circuit so as to implement a method for protecting against reversible errors according to any one of the preceding claims.

10. Assembly of at least one digital integrated circuit according to claim 9, comprising an input FIFO memory (FIFOₑ) for supplying samples to each processing channel, an output FIFO memory (FIFOₛ) for receiving samples from the error detection unit, a buffer memory (RAM) supplied with samples by the input FIFO memory (FIFOₑ), the controller (104) being capable of controlling read access to the input FIFO memory (FIFOₑ) and write access to the output FIFO memory (FIFOₛ) and being configured to execute a replay mechanism consisting of resetting each functional logic block (BLF), suspending read access to the input FIFO memory (FIFOₑ), suspending write access to the output FIFO memory (FIFOₛ) and switching the input of the processing channels to the output of the buffer memory (RAM).

11. Assembly of at least one digital integrated circuit according to any one of claims 9 or 10, further comprising a self-test stimulus generator (AS) capable of generating an input self-test sequence, a memory comprising a self-test sequence expected at the output of each block (BLF) and an error detection unit (AC) capable of comparing the sequence obtained at the output of each functional logic block (BLF) when the input self-test sequence is injected at the input with the expected self-test sequence stored in the second memory.

12. Assembly of at least one digital integrated circuit according to any one of claims 9 to 11, wherein each functional logic block (BLF) further comprises a modulo logic operator (MOD) applicable to the input data and wherein the logic functions of the functional logic block are implemented via a projection (PROJ) onto a component of an RNS base.

13. Assembly of at least one digital integrated circuit according to claim 12, further comprising a module (CAD) for adjusting the range of the numbers at the input of each functional logic block (BLF) in order to adapt their dynamic range.

14. Assembly of at least one digital integrated circuit according to any one of claims 9 to 13, comprising a source integrated circuit, several slave integrated circuits and a master integrated circuit, the various processing channels being distributed across the various slave integrated circuits.
